# FASCICULE DE BREVET EUROPEEN

(11) **EP 4 000 107 B1**
(45) Date de publication et mention de la délivrance du brevet: **03.12.2025**
(21) Numéro de dépôt: 20739421.4
(22) Date de dépôt: 16.07.2020
(51) Int. Cl.: H10H 20/815, H10H 20/818, H10H 20/821

(54) **DIODE ÉLECTROLUMINESCENTE ET PROCÉDÉ DE FABRICATION**
LEUCHTDIODE UND HERSTELLUNGSPROZESS
LIGHT EMITTING DIODE AND MANUFACTURING PROCESS

(30) Priorité: 18.07.2019 FR 1908165
(43) Date de publication de la demande: 25.05.2022
(73) Titulaire: Aledia, 38130 Echirolles (FR)
(72) Inventeur: NAPIERALA, Jérôme, 38120 SAINT EGREVE (FR)
(74) Mandataire: Hautier IP
(86) Numéro de dépôt international: PCT/EP2020/070212
(87) Numéro de publication internationale: WO 2021/009316

(56) Documents cités:
- US-A1- 2011 064 103
- US-A1- 2011 064 103
- US-A1- 2016 072 007
- US-A1- 2016 072 007
- P. DE MIERRY ET AL: "Green emission from semipolar InGaN quantum wells grown on low-defect (112 2) GaN templates fabricated on patterned r -sapphire : Green emission from semipolar InGaN quantum wells", PHYSICA STATUS SOLIDI. B, BASIC RESEARCH., vol. 253, no. 1, 25 November 2015 (2015-11-25), DE, pages 105 - 111, XP055673594, ISSN: 0370-1972, DOI: 10.1002/pssb.201552298
- YOUNG-HO KO ET AL: "Red Emission of InGaN/GaN Double Heterostructures on GaN Nanopyramid Structures", ACS PHOTONICS, vol. 2, no. 4, 13 February 2015 (2015-02-13), pages 515 - 520, XP055674226, ISSN: 2330-4022, DOI: 10.1021/ph500415c
- YUJI ZHAO ET AL: "Toward ultimate efficiency: progress and prospects on planar and 3D nanostructured nonpolar and semipolar InGaN light-emitting diodes", ADVANCES IN OPTICS AND PHOTONICS, vol. 10, no. 1, 16 February 2018 (2018-02-16), pages 246, XP055607007, DOI: 10.1364/AOP.10.000246
- P. DE MIERRY ET AL: "Green emission from semipolar InGaN quantum wells grown on low-defect (112 2) GaN templates fabricated on patterned r -sapphire : Green emission from semipolar InGaN quantum wells", PHYSICA STATUS SOLIDI. B, BASIC RESEARCH., vol. 253, no. 1, 25 November 2015 (2015-11-25), DE, pages 105 - 111, XP055673594, ISSN: 0370-1972, DOI: 10.1002/pssb.201552298
- YOUNG-HO KO ET AL: "Red Emission of InGaN/GaN Double Heterostructures on GaN Nanopyramid Structures", ACS PHOTONICS, vol. 2, no. 4, 13 February 2015 (2015-02-13), pages 515 - 520, XP055674226, ISSN: 2330-4022, DOI: 10.1021/ph500415c
- YUJI ZHAO ET AL: "Toward ultimate efficiency: progress and prospects on planar and 3D nanostructured nonpolar and semipolar InGaN light-emitting diodes", ADVANCES IN OPTICS AND PHOTONICS, vol. 10, no. 1, 16 February 2018 (2018-02-16), pages 246, XP055607007, DOI: 10.1364/AOP.10.000246

## Description

### DOMAINE TECHNIQUE

L'invention concerne le domaine de l'optoélectronique. Elle trouve pour application particulièrement avantageuse le domaine des diodes électroluminescentes à base de nitrure de Gallium (GaN) présentant une structure tridimensionnelle.

### ÉTAT DE LA TECHNIQUE

Les diodes électroluminescentes (LED) à base de nitrure de Gallium (GaN) sont généralement fabriquées selon une technologie dite planaire, qui consiste à former sur un plan de base un empilement de couches bidimensionnelles (2D) selon une direction normale au plan de base.

Cet empilement comprend généralement une région dite active où se produisent des recombinaisons radiatives de paires électron-trou, qui permettent d'obtenir un rayonnement lumineux présentant une longueur d'onde principale.

Pour des applications d'affichage, les LED peuvent être configurées pour produire un rayonnement lumineux dont la longueur d'onde principale se situe dans le bleu, ou dans le vert, ou dans le rouge.

Une structuration de cet empilement *a posteriori*, par exemple par des étapes de lithographie/gravure, permet ensuite de former une pluralité de diodes électroluminescentes présentant chacune une structure en mésa. La structure en mésa présente typiquement une face sommitale et des parois latérales. Ces parois latérales obtenues par structuration *a posteriori* présentent généralement des défauts favorisant l'apparition de recombinaisons non radiatives de surface.

Dans le cas de micro-LED, pour une taille de mésa inférieure à quelques dizaines de microns, par exemple inférieure à 10 µm, le rapport surface/volume du mésa augmente et l'influence des parois latérales devient non négligeable. En particulier, le taux de recombinaisons non radiatives d'une telle micro-LED augmente, en raison de la part croissante de recombinaisons non radiatives de surface. Le rendement de ces micro-LED est dès lors détérioré.

Pour réduire les défauts des parois latérales des mésas, une formation directe d'une structure tridimensionnelle (3D) est une alternative prometteuse à la structuration d'un empilement planaire bidimensionnel (2D). Une telle alternative permet notamment de réduire significativement le taux de recombinaisons non radiatives de surface.

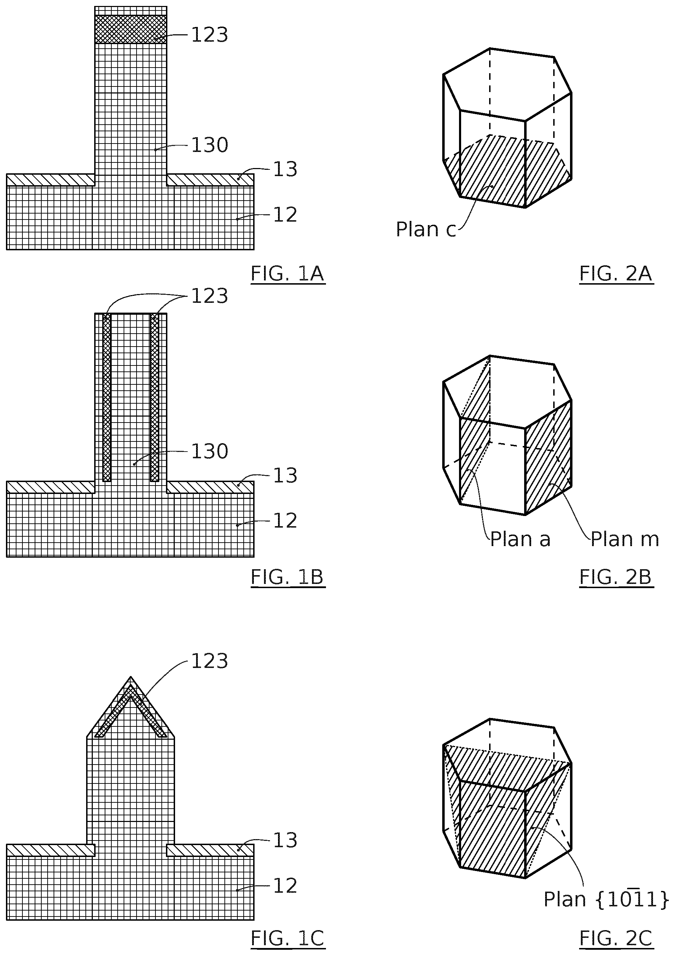

Les figures 1A et 1B présentent de telles structures 3D utilisées pour la fabrication de LED et/ou de micro-LED.

Ces structures 3D peuvent se présenter sous forme de microfils ou de nanofils à base de GaN s'étendant principalement selon une direction normale au plan basal.

Ils peuvent être formés par croissance épitaxiale à partir d'une couche de nucléation 12 partiellement recouverte par une couche de masquage 13.

Dans ces exemples, la couche de nucléation 12 est bidimensionnelle et s'étend dans le plan basal. La croissance des structures 3D se fait au travers des ouvertures 130 de la couche de masquage 13.

Ces structures 3D peuvent présenter différentes architectures internes.

La figure 1A illustre une première architecture dite axiale. Selon cette architecture axiale, la région active 123 s'étend de façon transverse, parallèlement au plan basal, au sein de la structure 3D.

Une telle architecture axiale permet notamment d'incorporer une concentration d'indium (In) importante dans la région active 123 à base de GaN. Une telle région active 123 peut émettre un rayonnement lumineux dont la longueur d'onde se situe dans le vert ou dans le rouge.

Cette architecture axiale peut donc être utilisée pour fabriquer des micro-LED 3D verte ou rouge.

Cependant, une telle architecture présente un faible rendement radiatif.

Par ailleurs, la distribution d'indium au niveau de la région active, pour des concentrations importantes d'Indium, n'est généralement pas homogène dans ce type d'architecture axiale.

La figure 1B illustre une deuxième architecture dite radiale. Selon cette architecture radiale, la région active 123 s'étend sur les flancs de la structure 3D, perpendiculairement au plan basal.

Une telle architecture radiale présente un bon rendement radiatif pour des LED émettant dans le bleu.

Cependant, ce rendement s'effondre pour des régions actives 123 radiales riche en indium émettant un rayonnement lumineux dont la longueur d'onde est supérieure à 500 nm.

Cette architecture radiale n'est donc pas optimale pour la fabrication de micro-LED 3D verte ou rouge.

Les solutions existantes de LED à structure 3D ne permettent donc pas d'obtenir une incorporation d'indium importante et un rendement radiatif élevé.

La présente invention vise à pallier au moins partiellement certains des inconvénients mentionnés ci-dessus.

En particulier, un objet de la présente invention est de proposer une diode électroluminescente (LED) à structure 3D à base de GaN permettant d'incorporer un taux d'indium important dans la région active tout en préservant, voire en augmentant, le rendement radiatif.

Un autre objet de la présente invention est de proposer une diode électroluminescente (LED) à structure 3D à base de GaN dont la distribution d'indium est homogénéisée.

Un autre objet de la présente invention est de proposer un procédé de fabrication d'une telle LED 3D GaN.

Les autres objets, caractéristiques et avantages de la présente invention apparaîtront à l'examen de la description suivante et des dessins d'accompagnement. Il est entendu que d'autres avantages peuvent être incorporés. Les documents US 2016/072007 A1 et YOUNG-HO KO ET AL: "Red Emission of InGaN/GaN Double Heterostructures on GaN Nanopyramid Structures" (2015-02-13; DOI: 10.1021/ph500415c) illustrent l'art antérieur des LEDs 3D à base de GaN et zone active incorporant de l'indium.

### RÉSUMÉ

Pour atteindre les objectifs mentionnés ci-dessus, la présente invention prévoit selon un premier aspect une diode électroluminescente (LED) présentant une structure tridimensionnelle (3D) à base de nitrure de gallium (GaN) et comprenant une région active à base de nitrure de gallium indium (InGaN) destinée à émettre un rayonnement lumineux. La structure tridimensionnelle (3D) se présente sous forme d'un fil au sommet effilé (structure 3D dite en crayon) ou sous forme d'une pyramide (structure 3D dite en pyramide).

Cette diode électroluminescente comprend en outre :
- une première couche à base de GaN présentant un premier taux d'Aluminium et un premier taux d'Indium, et
- une deuxième couche à base de GaN intercalée entre la première couche et la région active et au contact de celles-ci, présentant un deuxième taux d'Aluminium et un deuxième taux d'Indium.

Le deuxième taux d'indium est strictement supérieur au premier taux d'indium de sorte à générer une formation de dislocations de désaccord de paramètres de maille au niveau d'une interface entre les première et deuxième couches.

La région active, les première et deuxième couches s'étendent selon des plans cristallographiques semi-polaires. Les premier et deuxième taux d'aluminium [Al]1 et [Al]2 sont non nuls et vérifient [Al]1/([In]1+[Al]1) 0.8 et [In]2/([In]2+[Al]2) ≥ 0.2, où [In]1 et [In]2 représentent respectivement les premier et deuxième taux d'indium.

Les développements ayant menés à la présente invention ont permis d'identifier que :
- l'incorporation d'indium dans la région active dépend notamment de la polarité des couches formant la région active et de la gestion des contraintes mécaniques dans la structure 3D,
- le taux de recombinaisons radiatives et, par suite, le rendement radiatif dépendent en partie de l'intensité du champ piézoélectrique induit dans la région active à base d'InGaN. Ce champ piézoélectrique dépend également de la polarité des couches formant la région active.

Il est apparu que les solutions existantes de LED à structure 3D ne permettent pas de contrôler l'incorporation d'indium, l'apparition de contraintes mécaniques et l'intensité du champ piézoélectrique de façon efficace.

Dans le cas d'une architecture axiale (figure 1A), la région active est formée sur des plans polaires (plans c ou -c de la structure cristallographique hexagonale du matériau à base de GaN, illustrée à la figure 2A) qui induisent un fort champ piézoélectrique au sein de la région active.

Ce fort champ piézoélectrique génère une séparation spatiale des porteurs de charge (électrons et trous). Cette séparation des porteurs diminue considérablement le taux de recombinaisons électrons-trous. L'efficacité quantique interne IQE (Internal Quantum Efficiency en anglais) et le rendement radiatif sont faibles.

Les plans polaires de l'architecture axiale permettent d'incorporer une quantité d'indium relativement importante dans la région active.

Cependant, en augmentant la concentration d'indium [In]ₐ dans la région active, par exemple pour [In]ₐ > 17%, le matériau à base d'InGaN de la région active est de plus en plus contraint mécaniquement. Des défauts structuraux peuvent dès lors se former par relaxation plastique des contraintes dans la région active. Cela réduit l'efficacité IQE et le rendement radiatif de la zone active. L'augmentation des contraintes mécaniques et/ou la relaxation plastique favorisent en outre une distribution d'indium inhomogène au sein de la région active.

Dans le cas d'une architecture radiale (figure 1B), la région active est formée sur des plans non polaires (plans a ou m de la structure cristallographique hexagonale du matériau à base de GaN, illustrée à la figure 2B).

La relaxation plastique des contraintes dans les plans non polaires apparaît plus tôt que dans les plans polaires. Une telle orientation cristallographique favorise l'apparition de défauts cristallins. Ces défauts cristallins, en particulier des fautes d'empilement, se forment et se propagent donc rapidement dans la région active.

Afin de minimiser l'intensité du champ piézoélectrique tout en optimisant l'incorporation d'indium dans la région active, la présente invention prévoit de former la région active sur des plans semi-polaires, tel qu'illustré aux figures 1C, 2C. Une telle architecture est dite pyramidale dans la suite.

Les plans semi-polaires présentent un champ piézoélectrique faible ou nul, contrairement aux plans polaires. Selon un exemple, les plans semi-polaires sont préférentiellement de type {10-11} (figure 2C) et présentent un champ piézoélectrique pratiquement nul.

L'efficacité quantique interne IQE de l'architecture pyramidale est ainsi améliorée par rapport à celle de l'architecture axiale.

L'émission du rayonnement lumineux à la longueur d'onde principale présente également une stabilité améliorée sur une large gamme de densité de courant.

Les plans semi-polaires permettent en outre d'incorporer une quantité d'indium plus importante que les plans non polaires.

Cette architecture pyramidale améliore également l'incorporation d'indium, relativement à l'architecture radiale.

Par ailleurs, pour relâcher efficacement les contraintes mécaniques au niveau de la région active, la présente invention prévoit de former dans la structure 3D, parallèlement aux plans semi-polaires, des première et deuxième couches à base de GaN respectivement pauvre en indium et riche en indium. Ces première et deuxième couches sont également désignées dans la suite par « structure de relaxation des contraintes ».

La différence de paramètre de maille entre les première et deuxième couches permet de générer des dislocations de désaccord de paramètres de maille, communément dénommées « misfit dislocations » ou « dislocations de misfit » selon la terminologie anglo-saxonne, à l'interface entre la première couche et la deuxième couche.

L'apparition des dislocations de misfit (MD) correspond à une relaxation plastique des première et deuxième couches.

La structure de relaxation des contraintes permet ainsi de former la région active sur un matériau à base de GaN relaxé.

Le taux d'indium incorporé dans cette région active peut donc être augmenté en minimisant la concentration de défauts structuraux dans cette région active.

Par ailleurs, l'uniformité de la distribution d'indium au sein de la région active au moins partiellement relaxée est améliorée.

Les première et deuxième couches sont également respectivement riche en aluminium (Ga(In)AlN) et pauvre en aluminium (Ga(Al)InN). L'ajout d'aluminium permet d'accentuer la différence de paramètres de maille entre les première et deuxième couches. Il n'est donc pas nécessaire de former une deuxième couche très riche en indium pour obtenir la différence de paramètres de maille requise pour l'apparition des MD. Cela permet d'éviter un phénomène d'absorption du rayonnement lumineux par une deuxième couche trop riche en indium.

De façon synergique, les dislocations de misfit générées par la structure de relaxation des contraintes sont confinées dans les plans semi-polaires de l'architecture pyramidale.

Les dislocations de misfit ne se propagent donc pas jusqu'à la région active, contrairement aux défauts structuraux générés dans les plans polaires ou non polaires.

La distance d nécessaire entre l'interface et la région active pour éviter une influence parasite des dislocations de misfit sur le fonctionnement de la région active, en particulier sur la zone de charge d'espace se développant au niveau de la région active, peut être minimisée.

Le confinement des dislocations de misfit au niveau de l'interface permet donc de limiter l'épaisseur de deuxième couche à une épaisseur inférieure à 150 nm, par exemple comprise entre 10 nm et 150 nm.

Une telle structure de relaxation des contraintes intégrée selon l'architecture pyramidale permet donc une gestion efficace des contraintes mécaniques. D'autres avantages liés à cette gestion des contraintes améliorée seront détaillés dans la suite. Cette gestion des contraintes améliorée permet globalement d'améliorer l'IQE.

Une LED basée sur cette architecture pyramidale à structure de relaxation de contraintes présente donc un rendement radiatif amélioré, en particulier pour des configurations d'émission de rayonnements lumineux dans le vert ou dans le rouge.

Un deuxième aspect de la présente invention concerne un procédé tel que décrit par la revendication 12 de fabrication d'une diode électroluminescente (LED) à base de nitrure de gallium (GaN) présentant une structure tridimensionnelle (3D), ladite diode comprenant une région active à base d'InGaN destinée à émettre un rayonnement lumineux.

Ce procédé comprend les étapes suivantes :
- Fournir des structures tridimensionnelles comprenant au moins une couche superficielle à base de GaN sur un substrat, ladite couche superficielle s'étendant selon des plans cristallographiques semi-polaires,
- Former sur la couche superficielle une première couche à base de GaN s'étendant selon lesdits plans cristallographiques semi-polaires et présentant un premier taux d'Aluminium et un premier taux d'Indium,
- Former directement sur la première couche une deuxième couche à base de GaN s'étendant selon lesdits plans cristallographiques semi-polaires et présentant un deuxième taux d'Aluminium et un deuxième taux d'Indium tel que le deuxième taux d'indium est strictement supérieur au premier taux d'indium, de façon à générer une formation de dislocations de désaccord de paramètres de maille au niveau d'une interface entre les première et deuxième couches,
- Former directement sur la deuxième couche la région active à base d'InGaN s'étendant selon lesdits plans cristallographiques semi-polaires.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans² lesquels :
- La FIGURE 1A illustre une structure de LED 3D à architecture axiale selon l'art antérieur.
- La FIGURE 1B illustre une structure de LED 3D à architecture radiale selon l'art antérieur.
- La FIGURE 1C illustre une structure de LED 3D à architecture pyramidale selon un mode de réalisation de la présente invention.
- La FIGURE 2A illustre un plan polaire de type c d'une structure cristallographique hexagonale.
- La FIGURE 2B illustre des plans non polaires de type a et m d'une structure cristallographique hexagonale.
- La FIGURE 2C illustre un plan semi-polaire de type {10-11} d'une structure cristallographique hexagonale.
- Les FIGURES 3A à 3D illustrent des étapes de fabrication d'une LED 3D à architecture pyramidale selon un mode de réalisation de la présente invention.
- Les FIGURES 4A à 4D illustrent des étapes de fabrication d'une LED 3D à architecture pyramidale selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différentes couches et régions des LED 3D ne sont pas représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement.

Selon un exemple, le premier taux d'indium est non nul.

Selon un exemple, le deuxième taux d'indium est strictement supérieur au deuxième taux d'aluminium.

Selon un exemple, le premier taux d'indium [In]1 est compris entre 0 et 10 %.

Selon un exemple, le deuxième taux d'indium [In]2 est compris entre 3 et 25 %.

Selon un exemple, le premier taux d'aluminium [Al]1 est compris entre 0 et 35 %.

Selon un exemple, le deuxième taux d'aluminium [Al]2 est compris entre 0 et 10 %.

Selon un exemple, l'interface est située à une distance d de la région active telle que d > 10 nm.

Selon un exemple, les plans cristallographiques semi-polaires sont de type {10-11}.

Selon un exemple, la LED est configurée pour émettre un rayonnement lumineux présentant une longueur d'onde comprise entre 500 nm et 650 nm.

Selon un exemple, la structure tridimensionnelle est formée à partir d'un substrat plan.

Selon un exemple, la structure tridimensionnelle est formée à partir d'un substrat tridimensionnel présentant une surface texturée.

Selon un exemple, le substrat est à base d'un matériau pris parmi du silicium, du GaN, du saphir.

L'invention selon son deuxième aspect comprend notamment les caractéristiques optionnelles ci-après pouvant être utilisées en association ou alternativement :
Selon un exemple, la formation des première et deuxième couches et de la région active se fait par épitaxie par jets moléculaires (MBE).

Selon un exemple, la formation des première et deuxième couches et de la région active se fait sur un substrat tridimensionnel présentant une surface texturée.

Selon un exemple, la formation de la région active se fait au moins en partie à une température supérieure à 550°C.

Dans la présente invention, la formation d'une structure de relaxation de contraintes selon une architecture pyramidale est en particulier dédiée à la fabrication de LED 3D.

L'invention peut être mise en œuvre plus largement pour différents dispositifs optoélectroniques à structure 3D comprenant une région active.

On entend par région active d'un dispositif optoélectronique la région depuis laquelle est émise la majorité du rayonnement lumineux fourni par ce dispositif, ou la région depuis laquelle est captée la majorité du rayonnement lumineux reçu par ce dispositif.

L'invention peut donc être également mise en œuvre dans le cadre de dispositifs laser ou photovoltaïque.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément.

Les étapes de formation des différentes couches et régions s'entendent au sens large : elles peuvent être réalisées en plusieurs sous-étapes qui ne sont pas forcément strictement successives.

Dans la présente invention des types de dopage sont indiqués. Ces dopages sont des exemples non limitatifs. L'invention couvre tous les modes de réalisation dans lesquels les dopages sont inversés. Ainsi, si un exemple de réalisation mentionne pour une première région un dopage P et pour une deuxième région un dopage N, la présente description décrit alors, implicitement au moins, l'exemple inverse dans lequel la première région présente un dopage N et la deuxième région un dopage P.

Un dopage noté P englobe tous les dopages par porteurs de charges positives quelle que soit la concentration de dopants. Ainsi, un dopage P peut s'entendre d'un dopage P, P+ ou P++. De même, un dopage noté N englobe tous les dopages par porteurs de charges négatives quelle que soit la concentration de dopants. Ainsi, un dopage N peut s'entendre d'un dopage N, N+ ou N++.

Les gammes de concentration de dopants associées à ces différents dopages sont les suivantes :
dopage P++ ou N++ : supérieur à 1 x 10²⁰ cm⁻³
dopage P+ ou N+ : 5 x 10¹⁸ cm⁻³ à 9 x 10¹⁹ cm⁻³
dopage P ou N : 1 x 10¹⁷ cm⁻³ à 5 x 10¹⁸ cm⁻³
dopage intrinsèque : 1 x 10¹⁵ cm⁻³ à 1 x 10¹⁷ cm⁻³

Dans la suite, les abréviations suivantes relatives à un matériau M sont éventuellement utilisées :
M-i réfère au matériau M intrinsèque ou non intentionnellement dopé, selon la terminologie habituellement utilisée dans le domaine de la microélectronique pour le suffixe -i.
M-n réfère au matériau M dopé N, N+ ou N++, selon la terminologie habituellement utilisée dans le domaine de la microélectronique pour le suffixe -n.
M-p réfère au matériau M dopé P, P+ ou P++, selon la terminologie habituellement utilisée dans le domaine de la microélectronique pour le suffixe -p.

Dans la présente demande de brevet, les termes « concentration », « taux » et « teneur » sont synonymes.

Plus particulièrement, une concentration peut être exprimée en unité relative telle que les fractions molaires ou atomiques, ou en unité absolue telle que le nombre d'atomes par centimètre cube (at.cm-3).

Dans la suite, les concentrations sont des fractions atomiques exprimées en %at, sauf mention contraire.

Dans la présente demande de brevet, les termes « diode électroluminescente », « LED » ou simplement « diode » sont employés en synonymes. Une « LED » peut également s'entendre d'une « micro-LED ».

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une LED à base de nitrure de gallium (GaN) peut par exemple comprendre du nitrure de gallium (GaN ou GaN-i) ou du nitrure de gallium dopé (GaN-p, GaN-n) ou encore du nitrure de gallium-indium (InGaN), du nitrure de gallium-aluminium (AlGaN) ou du nitrure de gallium avec différentes teneurs en aluminium et en indium (GaInAlN). Dans le cadre de la présente invention, le matériau M est généralement cristallin.

Dans la présente demande de brevet, on parlera préférentiellement d'épaisseur pour une couche et de hauteur pour un dispositif. L'épaisseur est prise selon une direction normale au plan d'extension principal de la couche, et la hauteur est prise perpendiculairement au plan basal du substrat.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

Pour déterminer la géométrie de la LED, les orientations cristallographiques et les compositions des différentes couches, on peut procéder à des analyses de Microscopie Electronique à Balayage (MEB) ou de Microscopie Electronique en Transmission (MET ou TEM pour l'acronyme anglais de « Transmission Electron Microscopy ») ou encore ou de Microscopie Electronique en Transmission à Balayage STEM (acronyme anglais de « Scanning Transmission Electron Microscopy »).

La micro-diffraction au sein d'un TEM permet de déterminer les orientations cristallographiques des différentes couches et régions.

Le TEM ou le STEM se prêtent également bien à l'observation et à l'identification des défauts structuraux, et notamment des dislocations de misfit. Différentes techniques listées ci-après de façon non exhaustive peuvent être mises en œuvre : l'imagerie en champ sombre (dark field) et en champ clair (bright field), en faisceau faible (weak beam), en diffraction aux grands angles HAADF (acronyme anglais de « High Angle Annular Dark Field »).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de dispositifs de petites tailles telles que des LED 3D. Elle peut être mise en œuvre sur des coupes métallurgiques au sein d'un Microscope Electronique à Balayage (MEB) ou sur des lames minces au sein d'un Microscope Electronique en Transmission (MET).

Toutes ces techniques permettent notamment de déterminer si le dispositif optoélectronique à structure 3D comprend une structure de relaxation de contraintes selon des plans semi-polaires, telle que décrite dans la présente invention.

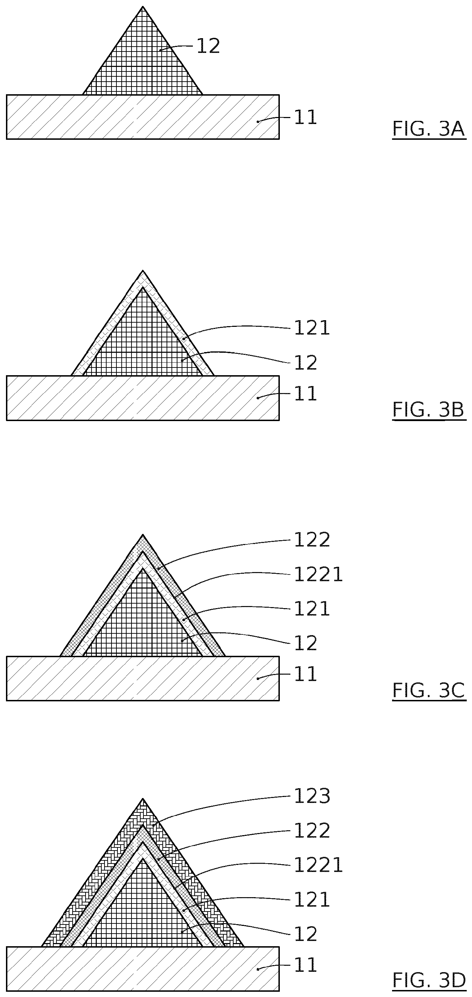

Un premier mode de réalisation d'une LED selon l'invention va maintenant être décrit en référence aux figures 3A à 3D.

Par souci de clarté, la description qui suit est basée sur une seule structure 3D élémentaire constitutive de la LED 3D. Il est entendu qu'une LED 3D peut comprendre une pluralité de structures 3D élémentaires adjacentes et distribuées sur un même substrat. Les autres structures 3D élémentaires de cette pluralité sont réputées être sensiblement identiques à la structure 3D élémentaire décrite ci-après.

La structure 3D élémentaire obtenue selon ce premier mode de réalisation est une pyramide à base de GaN.

Une structure porteuse 12 en forme de pyramide est formée lors d'une première étape (figure 3A).

Les flancs de la structure porteuse 12 en forme de pyramide sont orientés selon des plans semi-polaires d'une structure cristallographique hexagonale dont l'axe c est perpendiculaire au plan basal.

Selon un exemple, ils peuvent présenter un angle d'environ 80° vis-à-vis du plan basal, de façon à correspondre approximativement à un plan semi-polaire de type {20-21}.

Selon un autre exemple, ils peuvent présenter un angle d'environ 60° vis-à-vis du plan basal, de façon à correspondre approximativement à un plan semi-polaire de type {10-11}.

Cette structure porteuse 12 peut être en un matériau à base de GaN.

Une telle structure peut être obtenue à partir d'un substrat 11 plan, par exemple en silicium ou en saphir, éventuellement surmonté par une couche de nucléation à base de GaN (non représentée).

Une couche de masquage, par exemple en nitrure de silicium Si₃N₄, comprenant des ouvertures peut permettre une croissance localisée du matériau à base de GaN. Ces ouvertures présentent typiquement une dimension, par exemple un diamètre ou un diamètre moyen, comprise entre 50 nm et 30 µm. La distance séparant deux ouvertures peut être comprise entre 100 nm et 10 µm. Ces ouvertures peuvent être réalisées par lithographie UV ou DUV (acronyme de Deep UV) ou par lithographie par faisceau électronique.

Selon une possibilité, la structure porteuse 12 croit au travers d'une ouverture de la couche de masquage. Le diamètre à la base de la structure porteuse 12 est donc sensiblement égal à celui de l'ouverture correspondante.

La croissance du matériau à base de GaN peut se faire par épitaxie par jets moléculaires MBE (acronyme anglais de « Molecular Beam Epitaxy »), par épitaxie en phase vapeur à précurseurs gazeux chlorés HVPE (acronyme de « Hydride Vapour Phase Epitaxy »), par dépôt chimique en phase vapeur CVD et MOCVD (acronymes de « Chemical Vapor Deposition » et de « MetalOrganic Chemical Vapor Deposition »), par épitaxie en phase vapeur à précurseurs organométalliques MOVPE (acronyme de « MetalOrganic Vapour Phase Epitaxy »). De façon optionnelle, des étapes classiques de préparation de surface (nettoyage chimique, traitement thermique) peuvent être effectuées préalablement à la croissance.

Des îlots de germination peuvent ainsi apparaitre en début de croissance au niveau des ouvertures de la couche de masquage et, selon les conditions de croissance, se développer sous forme de pyramides au cours de la croissance. En particulier, des conditions de croissance pour lesquelles le rapport d'éléments V/III, typiquement le rapport Ga/N, est supérieur ou égal à 100 favorisent la croissance de ces îlots sous forme de pyramides.

Une structure porteuse 12 en forme de pyramide à base de GaN est ainsi obtenue (figure 3A).

Selon un exemple, le matériau à base de GaN de cette structure porteuse 12 peut être un alliage d'InGaN qui est classiquement utilisé pour la fabrication de LED verte ou rouge.

Une telle structure porteuse 12 en InGaN massive présente cependant une absorption significative à la longueur d'onde d'émission du rayonnement lumineux vert ou rouge.

La présente invention prévoit une structure de relaxation des contraintes qui permet de s'affranchir de l'utilisation d'une structure porteuse en InGaN massive, généralement nécessaire à la formation ultérieure d'une région active à base d'InGaN.

Dès lors et de façon préférée, le matériau à base de GaN de la structure porteuse 12 peut être en GaN massif. L'absorption par la structure porteuse 12 du rayonnement lumineux émis par la LED est ainsi fortement réduit. Le rendement de la LED peut être amélioré.

Selon un autre exemple, le matériau à base de GaN de cette structure porteuse 12 peut être un alliage d'AlGa(In)N dont la teneur en aluminium est supérieure à la teneur en indium.

De façon alternative, le substrat 11 lui-même peut être texturé de façon à présenter en surface des îlots pyramidaux.

Une couche mince de GaN ou d'InGaN peut dans ce cas être déposée sur ces îlots pyramidaux de sorte à former la ou les structures porteuses 12.

Dans ce cas, la structure porteuse 12 peut être constituée majoritairement par le matériau du substrat, par exemple du silicium, et par la couche mince à base de GaN surmontant ce matériau.

La structure porteuse 12 peut comprendre une région à base de GaN dopée N. De façon connue, cette région dopée N peut résulter d'une croissance, d'une implantation et/ou d'un recuit d'activation. Le dopage N peut notamment s'obtenir directement lors de la croissance, à partir d'une source de silicium ou de germanium, par exemple par addition de vapeur silane ou disilane ou germane.

La première couche 121 de la structure de relaxation des contraintes peut ensuite être formée, lors d'une deuxième étape (figure 3B).

Elle est à base de GaAl(In)N, et de préférence à base de GaAlN.

La concentration d'indium [In]₁ de cette première couche 121 peut être comprise entre 0 et 10%.

La concentration d'aluminium [Al]₁ de cette première couche 121 peut être comprise entre 0 (exclu) et 35%.

La première couche 121 présente une épaisseur de préférence comprise entre 10 nm et 150 nm.

La deuxième couche 122 de la structure de relaxation des contraintes est ensuite formée directement au contact de la première couche 121, lors d'une troisième étape (figure 3C).

Elle est à base de GalnAlN.

La concentration d'indium [In]₂ de cette deuxième couche 122 peut être comprise entre 3 et 25%.

La concentration d'aluminium [Al]2 de cette deuxième couche 122 peut être comprise entre 0 (exclu) et 10%.

La deuxième couche 122 présente une épaisseur de préférence comprise entre 10 nm et 150nm.

Les concentrations respectives [In]₁, [In]₂, [Al]₁, [Al]₂ sont choisies de façon à générer des dislocations de misfit à l'interface 1221 entre les première et deuxième couches 121, 122, tout en minimisant l'absorption du rayonnement lumineux émis par la LED par lesdites première et deuxième couches 121, 122.

Selon un exemple comparatif ne faisant pas partie de l'invention telle que revendiquée, les concentrations d'aluminium [Al]₁ et [Al]₂ sont nulles, et les concentrations d'indium [In]₁ et [In]₂ sont telles que [In]₂ > [In]₁ et de préférence [In]₂ - [In]₁ > 10%.

Selon l'invention, les concentrations d'aluminium [Al]₁ et [Al]₂ sont non nulles et vérifient [Al]₁/([In]₁+[Al]₁) ≥ 0.8 et [In]₂/([In]₂+[Al]₂) ≥ 0.2.

Pour des concentrations d'indium [In]₁ et [In]₂ données, une concentration d'aluminium [Al]₁ non nulle permet d'accentuer la différence de paramètre de maille entre les première et deuxième couches 121, 122. Cela permet en conséquence d'abaisser la concentration d'indium [In]₂ tout en préservant la formation des dislocations de misfit à l'interface 1221 entre les première et deuxième couches 121, 122.

Cette diminution relative de la concentration d'indium [In]₂ permet de limiter l'absorption de la deuxième couche 122.

Les première et deuxième couches 121, 122 peuvent être formées par épitaxie par jets moléculaires MBE (acronyme anglais de « Molecular Beam Epitaxy »), par épitaxie en phase vapeur à précurseurs gazeux chlorés HVPE (acronyme de « Hydride Vapour Phase Epitaxy »), par dépôt chimique en phase vapeur CVD et MOCVD (acronymes de « Chemical Vapor Deposition » et de « MetalOrganic Chemical Vapor Deposition »), par épitaxie en phase vapeur à précurseurs organométalliques MOVPE (acronyme de « MetalOrganic Vapour Phase Epitaxy »).

La structure de relaxation des contraintes permet de mieux répartir le budget des contraintes dans les différentes couches et régions de la structure 3D de la LED. Elle est donc particulièrement avantageuse dans le cadre d'une bonne ingénierie des contraintes lors de la conception de la LED ou du dispositif optoélectronique.

La structure de relaxation des contraintes permet par exemple de répartir uniformément la distribution des contraintes dans la structure 3D de la LED. L'uniformité de la distribution d'indium dans les différentes couches et régions de la structure 3D peut ainsi être améliorée.

Cette structure a également pour objectif de former une deuxième couche 122 à base d'InGaN présentant un taux de contraintes résiduelles faible ou nul, au moins dans une partie supérieure de cette couche 122.

L'orientation particulière de cette structure selon des plans semi-polaires permet notamment de confiner les dislocations de misfit au niveau de l'interface 1221. La partie supérieure de la couche 122 est préservée. Elle ne présente pas ou peu de défauts structuraux.

L'étape suivante vise à former une région active 123 à base d'InGaN sur cette partie supérieure de la couche 122 (figure 3D).

Cette région active 123 peut être formée par les mêmes techniques d'épitaxie ou de dépôt mises en œuvre pour former les première et deuxième couches 121, 122. Elles peuvent en particulier être formées dans un même bâti de croissance.

La région active 123 peut comprendre de façon connue une alternance de puits quantiques InGaN et de barrières GaN ou AlGaN.

La croissance par épitaxie de cette région active 123 se fait sur une couche 122 partiellement ou totalement relaxée.

La qualité cristalline de la région 123 est dès lors améliorée.

La distribution d'indium au sein des puits quantiques de cette région active 123 présente également une meilleure uniformité.

Il est ainsi possible d'augmenter la teneur en indium des puits quantiques de la région active 123 tout en conservant une bonne qualité cristalline et une bonne uniformité de distribution d'indium.

La température de croissance des puits quantiques à haute teneur en indium peut ainsi être augmentée. En particulier, une température de croissance de l'ordre de ou supérieure à 550°C peut être utilisée. Cela favorise également l'obtention de puits quantiques à base d'InGaN présentant une bonne qualité cristalline.

L'épaisseur des puits quantiques d'InGaN peut également être augmentée sans dépasser le budget total de contraintes admissibles. Cela permet de limiter le phénomène de pertes Auger dans la région active 123.

Le rendement radiatif est donc amélioré.

Une couche formant une région à base de GaN dopée P peut ensuite être déposée sur la région active 123, afin de compléter la structure de LED 3D. De façon connue, cette région dopée P peut résulter d'une croissance, d'une implantation et/ou d'un recuit d'activation.

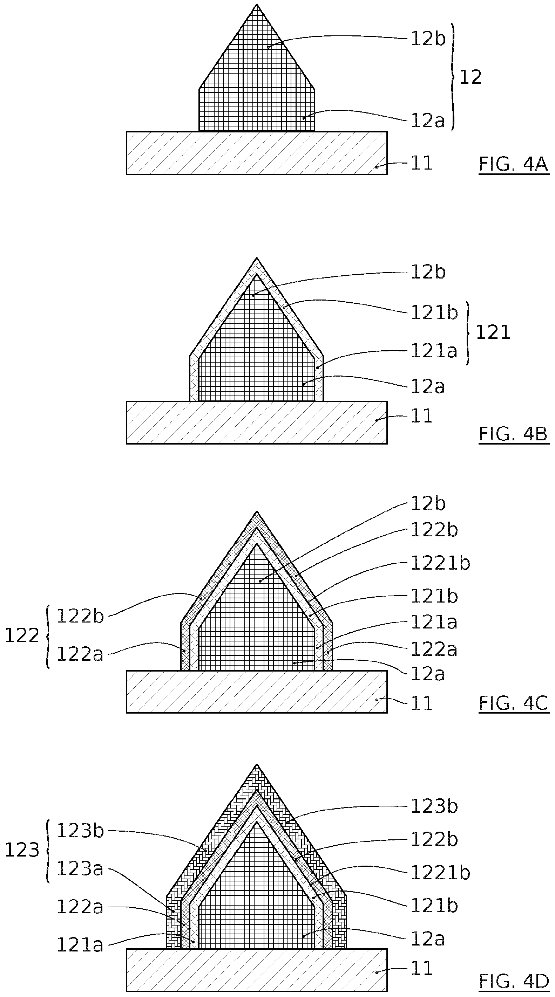

Un deuxième mode de réalisation d'une LED selon l'invention est illustré aux aux figures 4A à 4D.

Seules les caractéristiques distinctives de ce deuxième mode de réalisation par rapport au premier mode de réalisation sont décrites dans la suite, les autres caractéristiques étant réputées identiques à celles du premier mode de réalisation.

La structure 3D élémentaire à base de GaN obtenue selon ce deuxième mode de réalisation est une structure en crayon et se présente sous forme d'un fil au sommet effilé.

Seule la morphologie de cette structure 3D selon ce deuxième mode de réalisation diffère vis-à-vis de la structure 3D selon le premier mode de réalisation.

La structure porteuse 12 en forme de crayon formée lors d'une première étape (figure 4A) comprend une base 12a et un sommet 12b.

Les flancs de la base 12a sont sensiblement orientés selon l'axe c d'une structure cristallographique hexagonale, perpendiculairement au plan basal.

Les flancs du sommet 12b sont orientés selon des plans semi-polaires de la structure cristallographique hexagonale.

Les première et deuxième couches 121, 122, et la région active 123 sont ensuite formées sur les flancs de la base 12a et sur les flancs du sommet 12b (figures 4B-4D).

Les étapes de formation des différentes couches 121, 122 et régions 123 du premier mode de réalisation peuvent être adaptées *mutatis mutandis* à ce deuxième mode de réalisation.

La formation de la première couche 121 comprend notamment la formation d'une portion 121a sur les flancs de la base 12a et la formation d'une portion 121b sur les flancs du sommet 12b. Les portions 121a et 121b de la première couche 121 sont continues (figure 4B).

La formation de la deuxième couche 122 comprend notamment la formation d'une portion 122a sur la portion 121a et la formation d'une portion 122b sur la portion 121b. Les portions 122a et 122b de la deuxième couche 122 sont continues (figure 4C). Les portions 121b, 122b forment une structure de relaxation de contraintes équivalente à celle du premier mode de réalisation. L'interface 1221b entre les portions 121b, 122b est équivalente à l'interface 1221 décrite et illustrée pour le premier mode de réalisation. Elle permet notamment de confiner les dislocations de misfit générées par la structure de relaxation de contraintes comprenant les portions 121b, 122b.

La formation de la région active 123 comprend notamment la formation d'une portion 123a sur la portion 122a et la formation d'une portion 123b sur la portion 122b. Les portions 123a et 123b de la région active 123 sont continues (figure 4D).

Du fait des orientations respectives des portions 121a, 122a, 123a d'une part, et des portions 121b, 122b, 123b d'autre part, les compositions des première et deuxième couches 121, 122 et de la région active 123 peuvent varier en fonction desdites portions.

En particulier les concentrations d'indium des portions 121a, 122a, 123a sont respectivement plus faibles que les concentrations d'indium des portions 121b, 122b, 123b. En revanche, les concentrations d'aluminium des portions 121a, 122a, 123a sont, le cas échéant, sensiblement égales à celles des portions 121b, 122b, 123b. Dès lors, l'injection électrique des porteurs de charge se fait préférentiellement au niveau des portions 121b, 122b, 123b. Le fonctionnement d'un dispositif optoélectronique basé sur une structure porteuse 12 en forme de crayon telle que décrite dans ce deuxième mode de réalisation est donc similaire au fonctionnement d'un dispositif optoélectronique basé sur une structure porteuse 12 en forme de pyramide telle que décrite dans le premier mode de réalisation. Les avantages mentionnés pour le premier mode de réalisation sont également valables pour ce deuxième mode de réalisation.

La présente invention concerne également un procédé de fabrication d'une LED 3D tel que décrit au travers des exemples de réalisation précédents.

L'invention n'est pas limitée aux modes de réalisations précédemment décrits et s'étend à tous les modes de réalisation couverts par les revendications.

## Revendications

1. Diode électroluminescente (LED) à base de nitrure de gallium (GaN) présentant une structure tridimensionnelle (3D) et comprenant une région active (123) à base d'InGaN destinée à émettre un rayonnement lumineux, ladite structure tridimensionnelle (3D) se présentant sous forme d'un fil au sommet effilé ou sous forme d'une pyramide, ladite diode comprenant en outre :
- une première couche (121) à base de GaN présentant un premier taux d'Aluminium [Al]1 et un premier taux d'Indium [In]1, et
- une deuxième couche (122) à base de GaN intercalée entre la première couche (121) et la région active (123) et au contact de celles-ci, ladite deuxième couche (122) présentant un deuxième taux d'Aluminium [Al]2 et un deuxième taux d'Indium [In]2, le deuxième taux d'indium étant strictement supérieur au premier taux d'indium de sorte à générer une formation de dislocations de désaccord de paramètres de maille au niveau d'une interface (1221) entre lesdites première et deuxième couches (121, 122),
la région active (123) et lesdites première et deuxième couches (121, 122) s'étendant selon des plans cristallographiques semi-polaires,
ladite diode étant **caractérisée en ce que** les premier et deuxième taux d'aluminium [Al]1 et [Al]2 sont non nuls et vérifient [Al]1/([In]1+[Al]1) ≥ 0.8 et [In]2/([In]2+[Al]2) ≥ 0.2.

2. **LED** selon la revendication précédente dans laquelle le premier taux d'indium est strictement inférieur au premier taux d'aluminium et le deuxième taux d'indium est strictement supérieur au deuxième taux d'aluminium.

3. LED selon l'une quelconque des revendications précédentes dans laquelle le premier taux d'indium [In]1 est compris entre 0 et 10 %.

4. LED selon l'une quelconque des revendications précédentes dans laquelle le deuxième taux d'indium [In]2 est compris entre 3 et 25%.

5. LED selon l'une quelconque des revendications précédentes dans laquelle le premier taux d'aluminium [Al]1 est compris entre 0 et 35%.

6. LED selon l'une quelconque des revendications précédentes dans laquelle le deuxième taux d'aluminium [Al]2 est compris entre 0 et 10 %.

7. LED selon l'une quelconque des revendications précédentes dans laquelle l'interface (1221) est située à une distance d de la région active (123) telle que d > 10nm.

8. LED selon l'une quelconque des revendications précédentes dans laquelle les plans cristallographiques semi-polaires sont de type {10-11}.

9. LED selon l'une quelconque des revendications précédentes configurée pour émettre un rayonnement lumineux présentant une longueur d'onde comprise entre 500 nm et 650 nm.

10. LED selon l'une quelconque des revendications précédentes dans laquelle la structure tridimensionnelle est formée à partir d'un substrat (11) tridimensionnel présentant une surface texturée.

11. LED selon la revendication précédente dans laquelle le substrat (11) est à base d'un matériau pris parmi du silicium, du GaN, du saphir.

12. Procédé de fabrication d'une diode électroluminescente (LED) à base de nitrure de gallium (GaN) présentant une structure tridimensionnelle (3D),
ladite structure tridimensionnelle (3D) se présentant sous forme d'un fil au sommet effilé ou sous forme d'une pyramide,
ladite diode comprenant une région active (123) à base d'InGaN destinée à émettre un rayonnement lumineux, ledit procédé comprenant les étapes suivantes :
- Fournir une structure tridimensionnelle comprenant au moins une couche superficielle à base de GaN sur un substrat, ladite couche superficielle s'étendant selon des plans cristallographiques semi-polaires,
- Former sur la couche superficielle une première couche (121) à base de GaN s'étendant selon lesdits plans cristallographiques semi-polaires et présentant un premier taux d'Aluminium [Al]1 et un premier taux d'Indium [In]1,
- Former directement sur la première couche (121) une deuxième couche (122) à base de GaN s'étendant selon lesdits plans cristallographiques semi-polaires et présentant un deuxième taux d'Aluminium [Al]2 et un deuxième taux d'Indium [In]2 tel que le deuxième taux d'indium est strictement supérieur au premier taux d'indium, et tel que les premier et deuxième taux d'aluminium [Al]1 et [Al]2 sont non nuls et vérifient [Al]1/([In]1+[Al]1) ≥ 0.8 et [In]2/([In]2+[Al]2) ≥ 0.2,
- Former directement sur la deuxième couche (122) la région active (123) à base d'InGaN s'étendant selon lesdits plans cristallographiques semi-polaires.

13. Procédé selon la revendication précédente dans lequel la formation des première et deuxième couches (121, 122) et de la région active (123) se fait sur un substrat (11) tridimensionnel présentant une surface texturée.

## Patentansprüche

1. Leuchtdiode (LED) auf Galliumnitrid-Basis (GaN), die eine dreidimensionale Struktur (3D) besitzt und einen aktiven Bereich (123) auf InGaN-Basis umfasst, der dazu bestimmt ist, eine Lichtstrahlung auszusenden, wobei die dreidimensionale Struktur (3D) in Form eines Fadens an der konischen Spitze oder in Form einer Pyramide vorliegt, wobei die Diode ferner Folgendes umfasst:
- eine erste GaN-basierte Schicht (121), die einen ersten Aluminiumgehalt [Al]1 und einen ersten Indiumgehalt [In]1 besitzt, und
- eine zweite Schicht (122) auf GaN-Basis, die zwischen die erste Schicht (121) und den aktiven Bereich (123) eingelegt und mit diesen in Kontakt steht, wobei die zweite Schicht (122) einen zweiten Aluminiumgehalt [Al]2 und einen zweiten Indiumgehalt [ln]2 besitzt, wobei der zweite Indiumgehalt strikt über dem ersten Indiumgehalt liegt, sodass eine Bildung von Diskrepanzverschiebungen von Maschenparametern an einer Schnittstelle (1221) zwischen der ersten und zweiten Schicht (121, 122) erzeugt wird,
wobei sich der aktive Bereich (123) und die erste und die zweite Schicht (121, 122) entlang halbpolarer kristallographischer Ebenen erstrecken,
wobei die Diode **dadurch gekennzeichnet ist, dass** die ersten und zweiten Aluminiumgehalte [Al]1 und [Al]2 nicht null sind und [Al]1/([ln]1+[Al]1) ≥ 0,8 und [ln]2/([ln]2+[Al]2) ≥ 0,2 überprüfen.

2. LED nach dem vorhergehenden Anspruch, wobei der erste Indiumgehalt strikt unter dem ersten Aluminiumgehalt und der zweite Indiumgehalt strikt über dem zweiten Aluminiumgehalt liegt.

3. LED nach einem der vorhergehenden Ansprüche, wobei der erste Indiumgehalt [ln]1 zwischen 0 und 10 % liegt.

4. LED nach einem der vorhergehenden Ansprüche, wobei der zweite Indiumgehalt [ln]2 zwischen 3 und 25 % liegt.

5. LED nach einem der vorhergehenden Ansprüche, wobei der erste Aluminiumgehalt [Al]1 zwischen 0 und 35 % liegt.

6. LED nach einem der vorhergehenden Ansprüche, wobei der zweite Aluminiumgehalt [Al]2 zwischen 0 und 10 % liegt.

7. LED nach einem der vorhergehenden Ansprüche, wobei sich die Schnittstelle (1221) in einem Abstand d von dem aktiven Bereich (123) wie d > 10 nm befindet.

8. LED nach einem der vorhergehenden Ansprüche, wobei die semipolaren kristallographischen Ebenen von dem Typ {10-11} sind.

9. LED nach einem der vorhergehenden Ansprüche, die so konfiguriert ist, dass sie eine Lichtstrahlung aussendet, die eine Wellenlänge zwischen 500 nm und 650 nm besitzt.

10. LED nach einem der vorhergehenden Ansprüche, wobei die dreidimensionale Struktur aus einem dreidimensionalen Substrat (11) mit einer strukturierten Oberfläche gebildet ist.

11. LED nach dem vorhergehenden Anspruch, wobei das Substrat (11) auf einem Material aus Silizium, GaN, Saphir basiert.

12. Verfahren zur Herstellung einer Leuchtdiode (LED) auf Galliumnitrid-Basis (GaN), die eine dreidimensionale Struktur (3D) besitzt, wobei die dreidimensionale Struktur (3D) in Form eines Drahtes an der konischen Spitze oder in Form einer Pyramide vorliegt,
wobei die Diode einen aktiven Bereich (123) auf InGaN-Basis umfasst, der dazu bestimmt ist, Lichtstrahlung auszusenden, wobei das Verfahren die folgenden Schritte umfasst:
- Bereitstellen einer dreidimensionalen Struktur, die mindestens eine Oberflächenschicht auf GaN-Basis auf einem Substrat umfasst, wobei sich die Oberflächenschicht entlang halbpolarer kristallographischer Ebenen erstreckt,
- Bilden, auf der Oberflächenschicht, einer ersten Schicht (121) auf GaN-Basis, die sich entlang der halbpolaren kristallographischen Ebenen erstreckt und einen ersten Aluminiumgehalt [Al]1 und einen ersten Indiumgehalt [In] 1 besitzt,
- Bilden, direkt auf der ersten Schicht (121), einer zweiten Schicht (122) auf GaN-Basis, die sich entlang der halbpolaren kristallographischen Ebenen erstreckt und einen zweiten Aluminiumgehalt [Al]2 und einen zweiten Indiumgehalt [ln]2 besitzt, sodass der zweite Indiumgehalt strikt über dem ersten Indiumgehalt liegt und sodass die ersten und zweiten Aluminiumgehalte [Al]1 und [Al]2 nicht null sind und [Al]1/([ln]1+[Al]1) ≥ 0,8 und [ln]2/([ln]2+[Al]2) ≥ 0,2 überprüfen,
- Bilden, direkt auf der zweiten Schicht (122), des aktiven Bereichs (123) auf InGaN-Basis, der sich entlang der semipolaren kristallographischen Ebenen erstreckt.

13. Verfahren nach dem vorhergehenden Anspruch, wobei die Bildung der ersten und zweiten Schichten (121, 122) und des aktiven Bereichs (123) auf einem dreidimensionalen Substrat (11) mit einer strukturierten Oberfläche erfolgt.

## Claims

1. Light-emitting diode (LED) based on gallium nitride (GaN) having a three-dimensional 3D) structure and comprising an InGaN-based active region (123) designed to emit light radiation, said three-dimensional (3D) structure being in the form of a wire with a tapered top or in the form of a pyramid, said diode further comprising:
- a first layer (121) based on GaN having a first proportion of aluminium [Al]1 and a first proportion of indium [In]1, and
- a second layer (122) based on GaN, interposed between the first layer (121) and the active region (123) and in contact with both, said second layer (122) having a second proportion of aluminium [Al]2 and a second proportion of indium [In]2, the second portion of indium being strictly greater than the first proportion of indium, so as to cause a formation of mesh parameter misalignment dislocations at an interface (1221) between said first and second layers (121, 122),
the active region (123) and said first and second layers (121, 122) extending along semipolar crystallographic planes,
said diode being **characterised in that** the first and second proportions of aluminium [Al]1 and [Al]2 are non-zero and satisfy [Al]1/([ln]1+[Al]1) ≥ 0.8 and [ln]2/([ln]2+[Al]2) ≥ 0.2.

2. LED according to the preceding claim, wherein the first proportion of indium is strictly lower than the first proportion of aluminium and the second proportion of indium is strictly higher than the second proportion of aluminium.

3. LED according to either one of the preceding claims, wherein the first proportion of indium [ln]1 is between 0 and 10%.

4. LED according to any one of the preceding claims, wherein the second proportion of indium [ln]2 is between 3 and 25%.

5. LED according to any one of the preceding claims, wherein the first proportion of aluminium [Al]1 is between 0 and 35%.

6. LED according to any one of the preceding claims, wherein the second proportion of aluminium [Al]2 is between 0 and 10%.

7. LED according to any one of the preceding claims, wherein the interface (1221) is located at a distance d from the active region (123) such that d > 10nm.

8. LED according to any one of the preceding claims, wherein the semipolar crystallographic planes are of the type {10-11}.

9. LED according to any one of the preceding claims, configured to emit a light radiation having a wavelength between 500 nm and 650 nm.

10. LED according to any one of the preceding claims, wherein the three-dimensional structure is formed from a three-dimensional substrate (11) having a textured surface.

11. LED according to the preceding claim, wherein the substrate (11) is based on a material selected from silicon, GaN, or sapphire.

12. Method for manufacturing a light-emitting diode (LED) based on gallium nitride (GaN) having a three-dimensional (3D) structure, said three-dimensional (3D) structure being in the form of a wire with a tapered top or in the form of a pyramid,
said diode comprising an active region (123) based on InGaN designed to emit light radiation, said method comprising the following steps:
- Providing a three-dimensional structure comprising at least one GaN-based surface layer on a substrate, said surface layer extending along semipolar crystallographic planes,
- Forming a first GaN-based layer (121) on the surface layer, extending along said semipolar crystallographic planes and having a first proportion of aluminium [Al]₁ and a first proportion of indium [In]1,
- Forming a second GaN-based layer (122) directly on the first layer (121), extending along said semipolar crystallographic planes and having a second proportion of aluminium [Al]2 and a second proportion of indium [In]2, such that the second proportion of indium is strictly greater than the first proportion of indium, and such that the first and second portions of aluminium [Al]1 and [Al]2 are non-zero and satisfy [Al]1/([In]1+[Al]1) ≥ 0.8 and [In]2/([In]2+[Al]2) ^{>}- 0.2,
- Forming directly on the second layer (122) the active region (123) based on InGaN, extending along said semipolar crystallographic planes.

13. Method according to the preceding claim, wherein the formation of the first and second layers (121, 122) and the active region (123) occurs on a three-dimensional substrate (11) having a textured surface.
